# EUROPEAN PATENT APPLICATION

(11) **EP 1 909 312 A1**
(43) Date of publication of application: **09.04.2008**
(21) Application number: 06732563.9
(22) Date of filing: 12.05.2006
(51) Int. Cl.: H01L 21/304, B24B 37/00, C09K 3/14

(54) **ABRASIVE AND PROCESS FOR PRODUCING SEMICONDUCTOR INTEGRATED-CIRCUIT UNIT**

(30) Priority: 28.06.2005 JP 2005188284
(71) Applicant: Asahi Glass Company, Limited, Chiyoda-ku, Tokyo 100-8405 (JP); AGC Seimi Chemical Co., Ltd., Chigasaki-shi, Kanagawa 253-8585 (JP)
(72) Inventor: TAKEMIYA, Satoshi c/o Asahi Glass Company, Limited, Tokyo 1008405 (JP)
(74) Representative: Müller-Boré & Partner Patentanwälte
(86) International application number: PCT/JP2006/309582
(87) International publication number: WO 2007/000852

(57) **Abstract**

In polishing of a surface to be polished in production of a semiconductor integrated circuit device, it is possible to obtain a flat surface of an insulating layer having an embedded metal wiring. Further, it is possible to obtain a semiconductor integrated circuit device having a highly planarized multilayer structure.

A polishing compound for chemical mechanical polishing to polish a surface to be polished for a semiconductor integrated circuit device, which comprises abrasive particles (A) having an average primary particle size in a range of from 5 to 300 nm and an association ratio in the polishing compound in a range from 1.5 to 5, an oxidizing agent (B), a protective film-forming agent (C), an acid (D), a basic compound (E) and water (F).

## Description

### TECHNICAL FIELD

The present invention relates to a polishing compound for chemical mechanical polishing to be used in a process for producing a semiconductor device, and a method for producing a semiconductor integrated circuit device. More particularly, it relates to a polishing compound for chemical and mechanical polishing suitable for forming an embedded metal wiring using a copper metal as a wiring material and a tantalum-type metal as a barrier layer material, and a method for producing a semiconductor integrated circuit device employing such a polishing compound.

### BACKGROUND ART

Recently, along with the progress in the integration and functionality of semiconductor integrated circuits, there has been a demand for development of microfabrication techniques for miniaturization and densification. Planarization techniques for interlayer insulating films and embedded wirings are important in semiconductor integrated circuit production processes, in particular, in the process of forming multilayered wirings. That is, as wirings are increasingly multilayered due to the miniaturization and densification in the semiconductor production processes, the degree of irregularity tends to increase in the surfaces of the individual layers, resulting in a situation where the difference in level exceeds the depth of focus in lithography. In order to avoid such a problem, high planarization techniques are important in the process of forming multilayered wirings.

As the material for such wirings, copper has been receiving attention because of its low resistivity as compared with conventional aluminum alloys and also because of its excellence in electromigration resistance. Since the vapor pressure of copper chloride gas is low, it is difficult to form copper into the shape of wirings by Reactive Ion Etching (RIE) which has been commonly used. Therefore, in order to form the wirings, a Damascene method is used. In this method, concave portions such as trench patterns and via holes, are formed in an insulating layer. A barrier layer is then formed thereon, and then copper is deposited to form a film by sputtering, plating, or the like so as to be embedded in the trench portions. Then, excess copper and barrier layer are removed by Chemical Mechanical Polishing (hereinafter referred to as "CMP") until the surface of the insulating layer is exposed, other than the portions corresponding to the concave portions, whereby the surface is planarized and embedded metal wirings are formed. Recently, a Dual Damascene method has been predominantly used, in which copper wirings having copper embedded in concave portions and via holes are simultaneously formed.

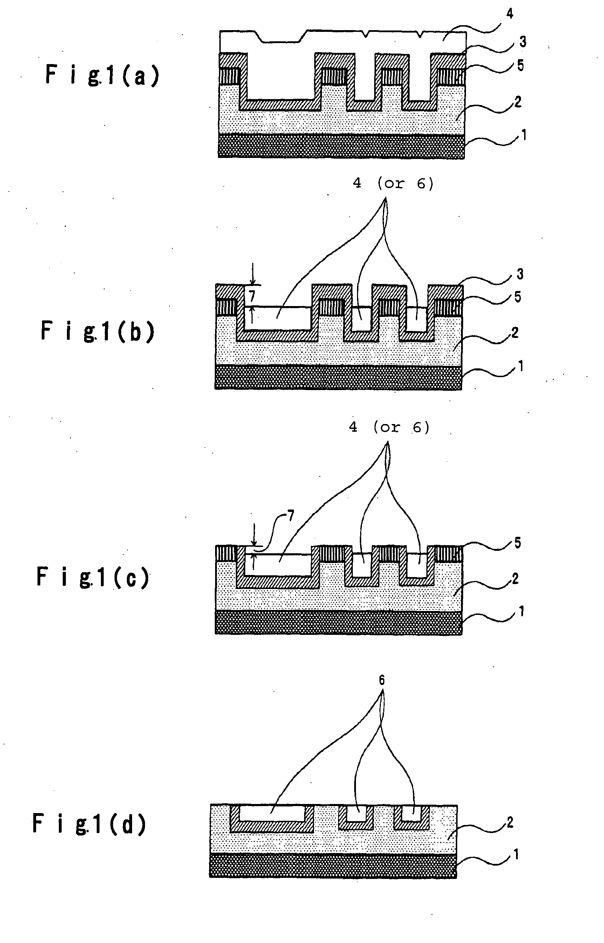

In the formation of copper-embedded wirings, in order to prevent copper from diffusing into the insulating layer, a barrier layer composed of tantalum, a tantalum alloy, or a tantalum compound such as tantalum nitride, is formed. Therefore, at portions other than those corresponding to copper-embedded wirings, the exposed barrier layer must be removed by CMP. However, since the barrier layer is significantly harder than copper, it is often not possible to achieve a sufficient removal rate. Accordingly, a two-stage polishing method has been proposed, which includes a first polishing step of removing an excess wiring metal layer and a second polishing step of removing an excess barrier layer, as shown in Fig. 1.

Fig. 1 includes cross-sectional views which show a method for forming embedded wirings by CMP. Fig. 1(a) shows the state before polishing; Fig. 1(b) shows the state after the first polishing step in which an excess metal wiring layer 4 is removed; Fig. 1(c) shows the state during the second polishing step in which an excess barrier layer 3 is removed; and Fig. 1(d) shows the state after completion of the second polishing step. In a case where a low dielectric constant material is used for the insulating layer, there may be a case where a cap layer made of an insulating material such as silicon dioxide is formed between the insulating layer and the barrier layer. Figs. 1(a) to 1(d) illustrate a case where a cap layer is present. In a case where the insulating layer is not a low dielectric constant film, like a silicon dioxide layer, no cap layer may be provided.

Firstly, as shown in Fig. 1(a), trenches are formed in an insulating layer 2. They are trenches to form embedded wirings 6 on a substrate 1. A cap layer 5, a barrier layer 3 and a metal wiring layer 4 are formed thereon, and in the first polishing step, an excess portion of the metal wiring layer 4 is removed. Then, in the first polishing step, an excess portion of the barrier layer 3 is removed. Usually, after completion of the first polishing step, a loss of the metal wiring layer so-called dishing 7 is observed. Accordingly, in the second polishing step, it becomes necessary to completely remove an excess portion of the barrier layer as shown in Fig. 1(c), further remove the cap layer 5 and if necessary, grind the insulating layer to align the remaining dishing 7 to be in the same plane as the metal wiring layer as shown in Fig. 1(d) to accomplish a high level of planarization.

Here, the cap layer 5 may not necessarily be completely removed. However, if the cap layer having a high relative dielectric constant remains, the relative dielectric constant of the entire insulating layer will be increased. Therefore, it is usually better to polish and remove the cap layer, whereby the characteristics of the device will be good. Fig. 1(d) illustrates a case wherein the cap layer is completely removed for planarization.

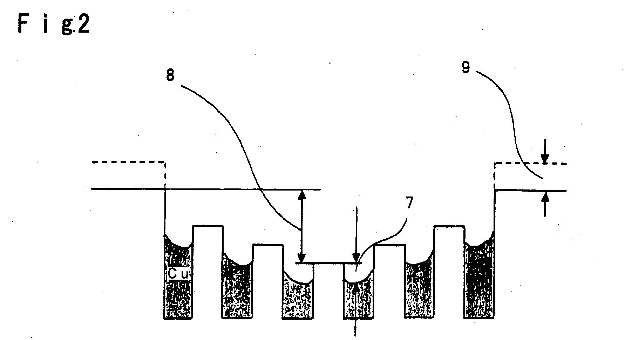

In such planarization, CMP using a conventional polishing compound, has had a problem that dishing and erosion in the copper-embedded wirings 6 tend to increase. Here, dishing means such a state that the metal wiring layer 4 is over-polished so that the central part thereof is concaved as shown by symbol 7 in Fig. 1(c) or in Fig. 2, and it is likely to occur in a wide wiring portion. Erosion is likely to occur in a fine wiring portion or a dense wiring portion and means such a phenomenon that the insulating layer 2 in the wiring portion is over-polished as compared with the insulating layer portion (Global portion) having no wiring pattern and the insulating layer 2 becomes thin as shown in Fig. 2. Namely, it means that an erosion portion 8 will be formed which is polished more than the polished portion 9 of the Global portion. In Fig. 2, the barrier layer 3 is not shown.

In a case where a conventional polishing compound is used, the removal rate of the barrier layer 3 was small as compared with the removal rate of the metal wiring layer 4, and accordingly, copper at the wiring portion was excessively polished during the removal of the barrier layer 3, thus leading to substantial dishing. Further, as compared with a portion where the wiring density is low, the polishing pressure exerted to the barrier layer 3 at a high density wiring portion or the insulating layer 2 beneath it tends to be relatively high, and accordingly, the progress degree of polishing in the second polishing step tends to be substantially different depending upon the wiring density. As a result, the insulating layer 2 at the high density wiring portion was excessively polished, thus leading to substantial erosion. Once dishing or erosion takes place, electromigration or an increase of the wiring resistance is likely to result, thus leading to a problem that the reliability of the device will decrease.

Tantalum or a tantalum compound to be used as the barrier layer is hardly etched chemically and has a high hardness as compared with copper, whereby its removal by polishing is not easy even mechanically. If the hardness of abrasive particles is increased in order to increase the removal rate, scratches are likely to be formed on the soft copper wirings, thus leading to a problem such as an electrical failure. Otherwise, if the concentration of abrasive particles in the polishing compound is increased, it tends to be difficult to maintain the dispersed state of abrasive particles in the polishing compound, and precipitation or gelation is likely to take place as the time passes, thus leading to a problem from the viewpoint of the dispersion stability.

Further, in CMP, it is necessary to prevent corrosion of copper during the polishing. Among corrosion inhibitors for copper and a copper alloy, most effectively and widely used ones are benzotriazole (hereinafter referred to as BTA) and its derivatives (e.g. Non-Patent Document 1). This BTA forms a dense film on the copper or copper alloy surface thereby to inhibit an oxidation-reduction reaction and prevent etching, and it is known that BTA is effective as an additive to prevent dishing of a copper wiring portion (e.g. Patent Document 1). However, if the amount of BTA is simply increased, the copper removal rate tends to decrease, and the polishing time tends to be long, whereby there has been a problem that defects such as dishing and erosion are likely to increase.

Further, water-soluble polymers have also been studied as one type of copper protective film-forming agents to inhibit dishing. Each of them is a polishing agent having a large removal rate ratio between metal and a barrier layer (metal/barrier layer) and a large removal rate ratio between metal and the insulating layer (metal/insulating layer). Namely, they are intended to inhibit polishing of the barrier layer or the insulating layer while polishing and removing copper at a high speed (e.g. Patent Document 2).

However, each of such studies is concerned with the first polishing step of polishing and removing the metal wiring layer (such as a copper wiring layer), and no effective polishing compound has been found with respect to a polishing compound for the second polishing step.

Now, problems in the second polishing step will be described with reference to a case of polishing an object to be polished wherein a barrier layer and a metal wiring layer are formed in this order on an insulating layer. Problems in a case where a cap layer is present on an insulating layer will be described thereafter.

In such a layer structure, in the second polishing step, it is required to polish the barrier layer at a high removal rate, to polish the metal wiring layer at a suitable removal rate and to grind the insulating layer to attain a high level of planarization.

Namely, while the polishing compound for the first polishing step is required primarily to polish the metal wiring layer at a high removal rate, the polishing compound for the second polishing step is required to polish the barrier layer at a high removal rate and to polish the insulating layer at a removal rate higher than the metal wiring layer. Thus, the required properties for the two are very much different.

As mentioned above, the role of the second polishing step in CMP is to completely remove an unnecessary barrier layer portion and at the same time to reduce the dishing formed in the first polishing step. In Fig. 1, in a case where the degree of dishing formed in the first polishing step is thinner than the thickness of the barrier layer, the dishing can be removed by grinding off only the barrier layer in the second polishing step, whereby polishing of the metal wiring layer, the insulating layer or the cap layer may not be required. However, the thickness of the barrier layer is usually as thin as from 20 to 40 nm, and in the first polishing step, the metal wiring layer is polished and removed at a high removal rate, whereby it is extremely difficult to control the dishing to be thinner than the thickness of the barrier layer. Further, in the first polishing step, if there is a local variation in the removal rate of the metal wiring layer, overpolishing will be required to completely remove the unnecessary wiring metal residue in the plane, whereby it becomes more difficult to control the dishing to be small.

Accordingly, in the second polishing step, it is required to repair the dishing larger than the thickness of the barrier layer, formed in the first polishing step, thereby to accomplish high planarization.

Further, usually, as shown in Fig. 2, especially in the case of fine wirings or high density wirings, the insulating layer 2 at the wiring portion is likely to be excessively polished as compared with the insulating layer portion having no wiring pattern (Global portion), and the insulating layer 2 is likely to become thin. In recent years, as the generation of semiconductors has advanced, and the wiring portion has become thinner, reduction of such erosion has become an important object.

When a cap layer is provided, there will be the following problem. In recent years, in order to reduce a wiring delay of LSI, a low dielectric constant material is employed for an insulating layer. However, the low dielectric constant material is chemomechanically brittle, and therefore, it is rare that a barrier layer is formed directly thereon, and it is common to firstly form a cap layer made of e.g. silicon dioxide on the insulating layer made of a low dielectric constant material (hereinafter the insulating layer made of a low dielectric constant material will be referred to also as "the low dielectric constant insulating layer") and then form a barrier layer. However, while the relative dielectric constant of the low dielectric constant material is usually at most 3, for example, the relative dielectric constant of silicon dioxide deposited by plasma CVD (chemical vapor deposition) is high at a level of 4. Accordingly, from the viewpoint of a low dielectric constant, it is not advisable to retain the cap layer at the time of planarization by polishing. Namely, it is advisable to remove the cap layer in the second polishing step.

However, if polishing time is prolonged to completely remove the cap layer, there has been a problem that the low dielectric constant insulating layer is likely to be removed more than necessary, since the removal rate usually substantially increases at the stage where the low dielectric constant insulating layer more brittle than the cap layer is exposed. In a case where the low dielectric constant insulating layer is removed too much, in order to planarize such a portion, the metal wiring layer is required to be further removed, and as a result, there will be a problem such that the excessively removed portion of the metal wiring layer will be substantial, and the electrical resistance will increase. In order to avoid removal of the low dielectric constant insulating layer after completely removing the cap layer, it is necessary to substantially suppress the removal rate of the low dielectric constant insulating layer as compared with the removal rate of the cap layer. However, it has been technically difficult to substantially suppress the removal rate of the low dielectric constant insulating layer chemomechanically more brittle than the cap layer, more than the removal rate of the cap layer.
Patent Document 1: JP-A-8-83780
Patent Document 2: JP-A-2001-144047
Patent Document 3: JP-A-2003-133267
Patent Document 4: JP-A-2002-141314
Non-Patent Document 1: Takenori Notoya, "Corrosion-inhibiting mechanism of benzotriazole type inhibitor and its application", Japan Association of Corrosion Control, 1986, p.1
Non-Patent Document 2: S. Brunauer, P.H. Emmit, and I. Teller "Journal of American Chemical Society", 1938, No. 1, Vol. 60, p. 309

### DISCLOSURE OF THE INVENTION

### OBJECTS TO BE ACCOMPLISHED BY THE INVENTION

It is an object of the present invention to realize a flat surface of an insulating layer having embedded metal wirings in polishing a surface to be polished in the production of a semiconductor integrated circuit device. Other objects and merits of the present invention will be apparent from the following description.

### MEANS TO ACCOMPLISH THE OBJECTS

The present invention provides the following (1) to (10).
(1) A polishing compound for chemical mechanical polishing to polish a surface to be polished in production of a semiconductor integrated circuit device, which comprises abrasive particles (A) having an average primary particle size in a range of from 5 to 300 nm and an association ratio in the polishing compound in a range from 1.5 to 5, an oxidizing agent (B), a protective film-forming agent (C), an acid (D), a basic compound (E) and water (F).
(2) The polishing compound according to the above (1), wherein the protective film-forming agent (C) is made of at least one material selected from the group consisting of a compound represented by the formula (1), wherein R₁ is a hydrogen atom, a C₁₋₄ alkyl group, a C₁₋₄ alkoxy group or a carboxyl group, and a compound represented by the formula (2), wherein each of R₂ and R₃ which are independent of each other, is a hydrogen atom, a C₁₋₄ alkyl group, a C₁₋₄ alkoxy group, a carboxyl group or an amino group: 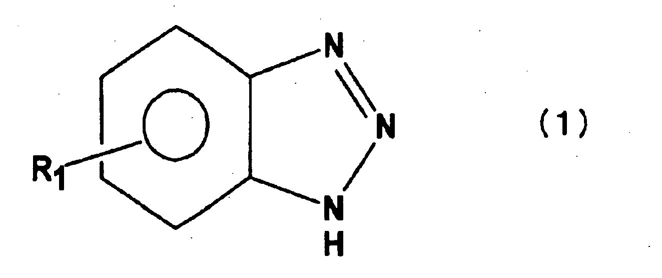 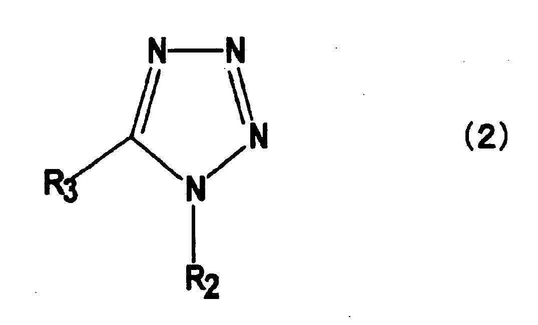
(3) The polishing compound according to the above (1) or (2), wherein the abrasive particles (A) are made of at least one material selected from the group consisting of silica, alumina, cerium oxide, zirconium oxide, titanium oxide, tin oxide, zinc oxide and manganese oxide.
(4) The polishing compound according to the above (3), wherein the abrasive particles (A) are made of colloidal silica.
(5) The polishing compound according to the above (1), (2), (3) or (4), which comprises from 0.1 to 20 mass% of the abrasive particles (A), from 0.01 to 50 mass% of the oxidizing agent (B), from 0.001 to 5 mass% of the protective film-forming agent (C), from 0.01 to 50 mass% of the acid (D), from 0.01 to 50 mass% of the basic compound (E) and from 40 to 98 mass% of water (F), based on the total mass of the above mentioned polishing compound being 100 mass%.
(6) The polishing compound according to the above (1), (2), (3), (4) or (5), which further contains a pH buffer and has a pH within a range of from 2 to 10.
(7) The polishing compound according to any one of the above (1) to (6), which is a polishing compound for polishing a surface to be polished in a case where a barrier layer and a metal wiring layer are formed in this order on an insulating layer.
(8) The polishing compound according to any one of the above (1) to (6), which is a polishing compound for polishing a surface to be polished in a case where a cap layer, a barrier layer and a metal wiring layer are formed in this order on an insulating layer made of a low dielectric constant material.
(9) The polishing compound according to the above (7) or (8), wherein the above metal wiring layer is made of copper, and the barrier layer is made of at least one member selected from the group consisting of tantalum, a tantalum alloy or a tantalum compound.
(10) A method for producing of a semiconductor integrated circuit device having a metal wiring layer embedded in an insulating layer, which comprises using the polishing compound as defined in any one of the above (1) to (9).

### EFFECTS OF THE INVENTION

According to the present invention, it is possible to obtain a flat surface of an insulating layer having embedded metal wirings, in polishing of a surface to be polished in the production of a semiconductor integrated circuit device. Further, it is possible to obtain a semiconductor integrated circuit device having a highly planarized multilayer structure.

### BRIEF DESCRIPTION OF THE DRAWINGS

Fig. 1 shows schematic cross sectional views of a semiconductor integrated circuit device in a process for forming embedded wirings by CMP.
Fig. 2 is a schematic cross sectional views of a semiconductor integrated circuit device to explain the definitions of dishing and erosion.

### MEANINGS OF SYMBOLS

- 1:: Si substrate
- 2:: Insulating layer
- 3:: Barrier layer
- 4:: Metal wiring layer
- 5:: Cap layer
- 6:: Embedded wirings
- 7:: Dishing portion
- 8:: Erosion portion
- 9:: Polished portion of Global portion

### BEST MODE FOR CARRYING OUT THE INVENTION

Now, embodiments of the present invention will be described with reference to the drawings, tables, formulae, Examples, etc. Such drawings, tables, formulae, Examples, etc. and the description are to exemplify the present invention and by no means restrict the scope of the present invention. Other embodiments may also belong to the scope of the present invention so long as they meet the concept of the present invention.

The polishing compound according to the present invention is a polishing compound for chemical mechanical polishing to polish a surface to be polished in production of a semiconductor integrated circuit device, and it is a polishing compound which comprises the abrasive particles (A), the oxidizing agent (B), the protective film-forming agent (C), the acid (D), the basic compound (E) and water (F), wherein the abrasive particles (A) have an average primary particle size within a range of from 5 to 300 nm and an association ratio in the polishing compound in a range of from 1.5 to 5. The polishing compound of the present invention has a slurry form.

When such a polishing compound is used in polishing a surface to be polished in production of a semiconductor integrated circuit device, it is possible to obtain a flat surface of an insulating layer having an embedded metal wiring layer. By preferentially polishing convex portions while suppressing preferential polishing of concave portions, it is possible to suppress formation of dishing or erosion.

Specifically, at the time of polishing a surface to be polished in a case where a barrier layer and a metal wiring layer are formed in this order on an insulating layer for a semiconductor integrated circuit device, it is possible to polish the barrier layer at a high removal rate and to polish the insulating layer (a cap layer when a cap layer is present) at a removal rate higher than the metal wiring wire. Namely, it is possible to obtain a performance suitable for the second polishing step. Further, at the time of polishing a surface to be polished including the cap layer and the metal wiring layer, after completely removing the cap layer, it is possible to planarize the surface to be polished while suppressing the removal of the insulating layer beneath the cap layer to be minimum.

With the polishing compound of the present invention, it is also possible to obtain a performance suitable for both the first polishing step and the second polishing step. Namely, at the time of polishing a surface to be polished in a case where a cap layer, a barrier layer and a metal wiring layer are formed in this order on an insulating layer, the polishing compound of the present invention may suitably be used for both the first polishing step and the second polishing step. However, it is particularly preferred to use the polishing compound in the second polishing step.

Further, with the composition of the above polishing compound, it is possible to reduce scratches in the metal wiring layer while obtaining the above effects. Therefore, it becomes easy to form an embedded wiring portion (a metal wiring layer) which is highly reliable and excellent in electrical characteristics. Further, in many cases, it is possible to realize a high removal rate. Further, the polishing compound of the present invention is usually excellent also in the dispersion stability of abrasive particles.

In the present invention, a "surface to be polished" means an intermediate stage surface appearing in the process for producing a semiconductor integrated circuit device. In the present invention, at least one of a metal wiring layer, a barrier layer, an insulating layer and a cap layer is an object to be polished. Accordingly, at the "surface to be polished" in the present invention, at least one of the metal wiring layer, the barrier layer, the insulating layer and the cap layer will be present.

Further, in the present invention, a "metal wiring layer" means a layer made of a planar metal wiring. However, it does not necessarily mean only a layer spread in one plane as shown in Fig. 1(a), but it includes a layer as an assembly of individual wirings 6 as shown in Fig. 1(c) or (d). Further, the "metal wiring layer" maybe considered to include a portion such as via holes for electrically connecting the planar metal wiring to another portion.

The abrasive particles (A) in the polishing compound may be suitably selected among known abrasive particles. Specifically, at least one member selected from silica, alumina, cerium oxide (ceria), zirconium oxide (zirconia), titanium oxide (titania), tin oxide, zinc oxide and manganese oxide, is preferred. As the silica, ones produced by various known methods may be used. For example, colloidal silica may be mentioned which is obtainable by hydrolyzing a silicon alkoxide compound such as ethyl silicate or methyl silicate by a sol-gel method. Further, colloidal silica obtained by ion exchange of sodium silicate or a fumed silica obtained by gas phase synthesis by reacting silicon tetrachloride in a flame of hydrogen and oxygen, may be mentioned.

Likewise, colloidal alumina may also be preferably used. Further, cerium oxide, zirconium oxide, titanium oxide, tin oxide or zinc oxide prepared in a liquid phase method or a gas phase method may also be preferably used. Among them, preferred is colloidal silica, of which the particle size can easily be controlled, and a high purity product can be obtained.

The average primary particle size of the abrasive particles (A) is required to be within a range of from 5 to 300 nm from the viewpoint of the polishing properties and the dispersion stability. The average primary particle size is preferably within a range of from 5 to 60 nm, more preferably within a range of from 10 to 60 nm. Further, the average secondary particle size of the abrasive particles (A) in the polishing compound is preferably within a range of from 8 to 300 nm.

The concentration of the abrasive particles (A) in the polishing compound of the present invention is preferably suitably set taking into consideration the removal rate, the uniformity in the removal rate in the wafer plane, the dispersion stability, etc., within a range of from 0.1 to 20 mass%, based on the total mass of the polishing compound being 100 mass%. The concentration is more preferably within a range of from 1 to 15 mass%, based on the total mass of the polishing compound.

As the abrasive particles (A), associated ones are used. The presence or absence of association can easily be ascertained by an electron microscope.

Conventional findings relating the CMP employing associated abrasive particles are disclosed in the following references. For example, Patent Document 3 discloses polishing particles employing irregular shape particles having two or more primary particles bonded to one another. Further, Patent Document 4 discloses a polishing compound comprising colloidal particles having an association degree of at most 5, an oxidizing agent, an oxidation-inhibitor, a surfactant and a basic compound.

Whereas, the present invention is based on a new finding such that in a polishing compound comprising abrasive particles (A), an oxidizing agent (B), a protective film-forming agent (C), an acid (D), a basic compound (E) and water (F), when the average primary particle size of the abrasive particles (A) is within a range of from 5 to 300 nm, and the association ratio of the abrasive particles in the polishing compound is within a range of from 1.5 to 5, it is possible to control the selective ratio of the insulating layer without lowering the removal rate of the barrier layer. Here, the average primary particle size may be measured at any stage until completed as a polishing compound, but the association ratio and the average secondary particle size are values in the final polishing compound. In a case where at the time of supplying to the polishing site, the polishing materials are mixed to form a composition of the polishing compound, the association ratio and the average secondary particle size will be measured with respect to the polishing compound after the mixing.

As a result of an extensive study, the present inventors have found that although an interrelation to some extent is observed between the association ratio of colloidal particles in an aqueous dispersion as shown in Patent Document 3 or 4 and the association ratio in the final polishing compound constituted by adding other components, the real measured results are substantially different, and it is possible to control the selective ratio of the insulating layer to be within a desired range by adjusting the association ratio in the final polishing compound to be within a range of from 1.5 to 5, and thus have arrived at the present invention. Here, more preferably, the association ratio in the final polishing compound is made to be within a range of from 1.5 to 2.5, further preferably within a range of from 1.7 to 2.5.

Particularly, by the above finding, the polishing compound of the present invention has a nature such that selectivity in the removal rate between the cap layer and the low dielectric constant insulating layer is imparted so that the removal rate decreases substantially at the stage when the low dielectric constant insulating layer is exposed after removal of the cap layer. Thus, the polishing compound of the present invention has a characteristic such that at the time of polishing a surface to be polished including the cap layer and the metal wiring layer, it is possible to planarize the surface to be polished after completely removing the cap layer while suppressing the removal of the low dielectric constant insulating layer beneath the cap layer to be minimum.

Such a characteristic is considered to be obtainable by a combination of chemical polishing attributable to the chemical composition of the polishing compound and mechanical polishing attributable to the association ratio of the abrasive particles, and it is an effect which has not be attained by any conventional polishing compound.

Here, the association ratio is defined to be a value obtained by dividing the average second particle size in the polishing compound slurry by the average primary particle size. The average primary particle size is obtained as a particle size of equivalent spheres from the specific surface area of the particles. The specific surface area of the particles is measured by a nitrogen adsorption method widely known as BET method. The details of this method are disclosed in Non-Patent Document 2. The average second particle size in the polishing compound is the diameter of an average aggregate of the polishing compound, which may be measured, for example, by means of a particle size distribution meter employing dynamic light scattering.

The oxidizing agent (B) in the present invention is used to form an oxide layer on the surface of the barrier layer and to accelerate polishing of the barrier layer by removing the oxide layer from the surface to be polished by a mechanical power.

With a view to obtaining a sufficient effect to accelerate the polishing, the concentration of the oxidizing agent (B) in the polishing compound is preferably suitably set in consideration of e.g. the removal rate within a range of from 0.01 to 50 mass% based on the total mass of the polishing compound being 100 mass%. It is more preferably within a range of from 0.2 to 20 mass% based on the total mass of the polishing compound.

The oxidizing agent (B) is preferably at least one member selected from hydrogen peroxide, an iodate, a periodate, a hypochlorite, a perchlorate, a persulfate, a percarbonate, a perborate and a perphosphate. As the iodate, the periodate, the hypochlorite, the perchlorate, the persulfate, the percarbonate, the perborate and the perphosphate, ammonium salts, or alkali compound metal salts such as potassium salts, may be used. Among them, preferred is hydrogen peroxide which contains no alkali metal component and is free from forming a hazardous byproduct.

The protective film-forming agent (C) in the present invention means an agent having a function to form a protective film on the surface of the metal wiring layer to prevent dishing of the metal wiring layer portion. For example, in a case where the metal wiring layer is made of copper or a copper alloy, it may be one which forms a film by physical adsorption or chemical adsorption on the copper surface, thereby to prevent elution of copper.

The protective film-forming agent (C) is preferably one made of at least one material selected from the group consisting of a compound represented by the formula (1) and a compound represented by the formula (2).

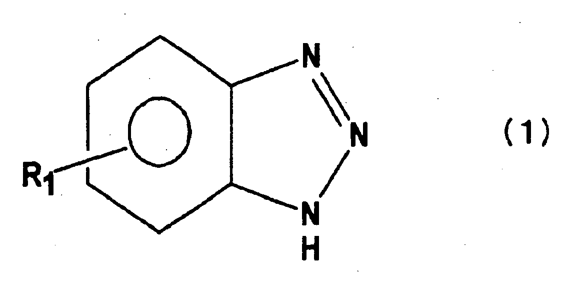

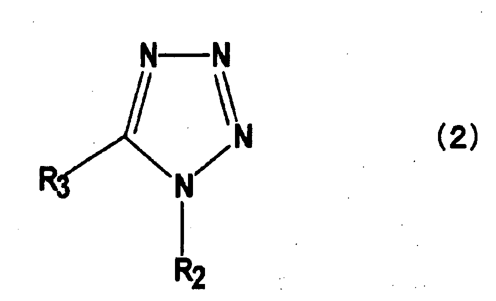

In the formula (1), R₁ is a hydrogen atom, a C₁₋₄ alkyl group, a C₁₋₄ alkoxy group or a carboxyl group. In the formula (2), each of R₂ and R₃ which are independent of each other, is a hydrogen atom, a C₁₋₄ alkyl group, a C₁₋₄ alkoxy group, a carboxyl group or an amino group.

The compound represented by the formula (1) may specifically be BTA, tolyltriazole (TTA) having a methyl group substituted for one hydrogen at the 4- or 5-position of the benzene ring of BTA, or benzotriazole-4-carboxylic acid having a carboxyl group substituted for such one hydrogen atom. The compound represented by the formula (2) may, for example, be 1H-tetrazole (1HT), 5-amino-1H-tetrazole (HAT) or 5-methyl-1H-tetrazole (M5T). These compounds may be used alone or in combination as a mixture of two or more of them. From the viewpoint of the polishing properties, the protective film-forming agent (C) is preferably contained within a range of from 0.001 to 5 mass%, more preferably within a range of from 0.01 to 1.0 mass%, based on the total mass of the polishing compound being 100 mass%.

In the polishing compound of the present invention, the acid (D) is contained in addition to the components (A) to (C). However, when the oxidizing agent functions also as an acid, it will be treated as the acid (D) i.e. not the oxidizing agent (B).

As such an acid (D), it is preferred to use at least one inorganic acid selected from nitric acid, sulfuric acid and hydrochloric acid. Among them, preferred is nitric acid which is an oxoacid having an oxidizing power and contains no halogen. Further, the concentration of the acid is preferably within a range of from 0.01 to 50 mass%, based on the total mass of the polishing compound being 100 mass%. It is more preferably within a range of from 0.01 to 20 mass%. By the addition of the acid (D), it is possible to increase the removal rate of the barrier layer or the insulating layer. Further, it is thereby possible to improve the dispersion stability of the polishing compound of the present invention.

In order to adjust the polishing compound of the present invention to a prescribed pH, at the same time as the acid, the basic compound (E) is added to the polishing compound. As the basic compound (E), it is possible to use ammonia, potassium hydroxide, a quaternary ammonium hydroxide such as tetramethylammonium hydroxide or tetraethylammonium hydroxide (hereinafter referred to as TEAH) or monoethanolamine. In a case where it is preferred not to contain an alkali metal, ammonia is preferred.

The acid (D) or the basic compound (E) may be added at any stage to the polishing compound of the present invention. For example, a case where those having components corresponding to (A) to (C) treated with an acid or a basic compound, are used as components of the polishing compound, corresponds to an addition of the above-described acid or basic compound. Further, all or part of the acid (D) and the basic compound (E) to be used, may be reacted to form a salt and then added. Further, in the present invention, it is preferred to separately add the acid (D) and the basic compound (E) from such a viewpoint that the removal rate of the barrier layer can be increased, or the pH of the polishing compound can easily be adjusted to be within the desired range, and from the viewpoint of the handling efficiency.

The concentration of the basic compound (E) in the polishing compound is preferably within a range of from 0.01 to 50 mass%, more preferably within a range of from 0.01 to 20 mass%, based on the total mass of the polishing compound being 100 mass%. In the case of a salt, the concentrations of the acid (D) and the basic compound (E) in the polishing compound, mean the concentrations in the case where the salt is assumed to be present in the form of an acid and a basic compound independently.

The polishing compound of the present invention is useful within a wide pH range of from 2 to 10. However, in consideration of the polishing properties and dispersion stability of the polishing compound, the pH in a case where silica is used as the abrasive particles, is preferably at most 4 or at least 7, and an acidic region (pH 2 to 4) and a neutral-basic region (pH 7 to 10) are used separately depending upon the desired removal rate of the metal wiring layer (such as copper). Namely, it is generally known that the dispersion stability of colloidal silica dispersed in water varied depending upon the pH, and in the above-mentioned two regions, colloidal silica is less susceptible to gelation. Further, in a case where the metal wiring layer is made of copper or a copper alloy, an equilibrium state of copper varies depending upon the pH and the electric potential, and accordingly, the pH is selected taking into consideration the type and content of the protective film-forming agent (C). For example, in an acidic region, copper is stable in an ionized state, and in a neutral to basic region, it is stable in the form of an oxide or hydroxide. In the present invention, the acidic region is preferred since a construction to combine with the protective film-forming agent (C) is employed.

In a case where the abrasive particles (A) are alumina or ceria, in consideration of their isoelectric points or gelation ranges, the pH is adjusted to the optimum value. For this purpose, a pH buffer may be used. As such a pH buffer, any one may be used so long as it is a substance having a usual pH-buffering ability. It is preferably one member selected from polyvalent carboxylic acids such as succinic acid, citric acid, oxalic acid, phthalic acid, tartaric acid and adipic acid. Or, glycylglycine or an alkali metal carbonate may also be used. The concentration of the pH buffer in the polishing compound of the present invention is preferably from 0.01 to 10 mass% based on the total mass of the polishing compound being 100 mass%. The pH buffer i.e. a substance having a pH-buffering ability, is not regarded as the above acid (D) or basic compound (E).

In the polishing compound of the present invention, water (F) is used to disperse the abrasive particles stably. The water to be used may be any one so long as it is not against the purpose of the present invention. However, it is preferred to use e.g. pure water or deionized water. It is preferred that water (F) is contained within a range of from 40 to 98 mass%, based on the total mass of the polishing compound being 100 mass%.

Further, in order to adjust the fluidity, dispersion stability of the polishing compound and the removal rate, it is preferred to add at least one organic solvent selected from the group consisting of a C₁₋₄ primary alcohol, a C₂₋₄ glycol, an ether represented by CH₃CH(OH) CH₂O-CₘH₂ₘ₊₁ (wherein m is an integer of from 1 to 4), N-methyl-2-pyrrolidone, N,N-dimethylformamide, dimethyl sulfoxide, γ-butyrolactone and propylene carbonate. Specifically, as the primary alcohol, methyl alcohol, ethyl alcohol or isopropyl alcohol is preferred. As the glycol, ethylene glycol or propylene glycol is preferred. As the ether, propylene glycol monomethyl ether or propylene glycol monoethyl ether is preferred. Further, N-methyl-2-pyrrolidone, N,N-dimethylformamide, dimethyl sulfoxide, γ-butyrolactone and propylene carbonate are polar solvents having a relative dielectric constant within a range of from 30 to 65 at 25°C and capable of dissolving an electrolyte at a high concentration by solvation.

In the polishing compound of the present invention, water (F) having a high surface tension is contained, and addition of the above-mentioned organic solvent is accordingly effective to adjust the fluidity. It is particularly preferred to use a compound represented by the formula (1) as the protective film-forming agent (C), whereby the above organic solvent serves also as a good solvent for the compound represented by the formula (1), and the concentration of the protective film-forming agent (C) in the polishing compound can easily be adjusted to be within the desired range.

Further, to the polishing compound of the present invention, a surfactant, a chelating agent, a reducing agent, a viscosity-imparting agent or viscosity-controlling agent, an agglomeration-preventing agent or dispersant, an anticorrosive, etc. may suitably be incorporated, as the case requires, unless such incorporation is against the purpose of the present invention. However, in a case where such an agent has a function as the oxidizing agent (B), the protective film-forming agent (C), the acid (D) or the basic compound (E), it is regarded as the oxidizing agent (B), the protective film-forming agent (C), the acid (D) or the basic compound (E).

The polishing compound of the present invention is not necessarily required to be supplied to the polishing site in such a form that all of the constituting polishing materials are preliminarily mixed. At the time of supplying to the polishing site, the polishing materials may be mixed to constitute the composition of the polishing compound.

The polishing compound of the present invention is capable of controlling also the removal rate of the metal wiring layer (such as copper) and thus is useful to obtain a flat surface of an insulating layer having an embedded metal wiring layer in production of a semiconductor integrated circuit device. It is particularly useful to polish a surface to be polished in a case where a barrier layer and a metal wiring layer are laminated on an insulating layer. Namely, the polishing compound of the present invention can simultaneously have both functions of polishing the barrier layer at a high removal rate and planarizing the insulating layer having an embedded metal wiring layer.

Especially when the barrier layer is a layer made of at least one member selected from tantalum, a tantalum alloy and a tantalum compound, a high effect can be obtained. However, it may be applied also to a layer made of other metal, and a sufficient effect can be obtained also in a case where as the barrier layer, a layer of a metal or metal compound other than tantalum, such as Ti, TiN, TiSiN or WN, is used.

The material constituting an insulating layer as one of objects to be polished by the polishing compound of the present invention may be any known material. Specifically, a silicon dioxide film may, for example, be mentioned. As the silicon dioxide film, one made of a crosslinked structure of Si and O wherein the ratio in number of Si atoms to O atoms is 1:2, is usually used, but other ones may also be used. As such a silicon dioxide film, one deposited by plasma CVD by using tetraethoxysilane (TEOS) or silane gas (SiH₄) is commonly known.

Further, in recent years, for the purpose of suppressing a signal delay, not only such a silicon dioxide film, but also a film made of a low dielectric constant material having a relative dielectric constant of at most 3 has been used as an insulating layer. As such a low dielectric constant material film, a film made of a fluorine added silicon oxide (SiOF), an organic SOG film (film containing an organic component obtained by spin on glass), a low dielectric constant material film such as a porous silica film, or a film of an organic silicon material (usually represented by SiOC) constituted mainly by SiO bonds and containing CH₃ bonds, is known. Such films may suitably be used as an insulating layer to which the polishing compound of the present invention may be applied.

An organic silicon material is on an extended line of the conventional technique as a process technique, and by carrying out a proper process tuning, a mass production technique having a wide application range has been accomplished. Accordingly, a technique to planarize a film prepared by using such a low dielectric constant material is desired, and the polishing compound of the present invention may be suitably used.

As an organic silicon material being a low dielectric constant material, tradename Black Diamond (relative dielectric constant: 2.7, manufactured using technology developed by Applied Materials, Inc.), tradename Coral (relative dielectric constant: 2.7, manufactured using technology developed by Novellus Systems), or Aurora 2.7 (relative dielectric constant: 2.7, manufactured using technology developed by ASM Japan K.K.) may, for example, be mentioned, and a compound having Si-CH₃ bonds is particularly preferably used.

The polishing compound of the present invention may suitably be used also in a case where a cap layer is formed on an insulating layer. For example, in a multilayered structure wherein a cap layer, a barrier layer and a metal wiring layer are laminated in this order on a low dielectric constant insulating layer, it is suitable to completely remove the cap layer and then to planarize the insulating layer without removing it so much.

In a case where a low dielectric constant material is used for the insulating layer, the cap layer is a layer provided for the purpose of improving the adhesion between the insulating layer and the barrier layer, using it as a mask material at the time of forming by etching a trench for embedding a metal wiring layer in the low dielectric constant insulating layer which is chemomechanically brittle, or preventing modification of the low dielectric constant material.

As the cap layer, a film comprising silicon and oxygen as constituting elements, is usually employed. As such a film, a silicon dioxide film may, for example, be mentioned. As the silicon dioxide film, one made of a crosslinked structure of Si and O, wherein the ratio in number of Si atoms and O atoms is 1:2, is usually employed, but other ones may be used. As such a silicon dioxide film, one deposited by plasma CVD by using tetraethoxysilane (TEOS) or silane gas (SiH₄), is commonly known.

The polishing compound of the present invention can be used particularly suitably in a case where as the cap layer in the present invention, a silicon dioxide film obtained by depositing tetraethoxysilane (TEOS) by CVD is used, and as the organic silicon material of the low dielectric constant material, tradename Black Diamond (relative dielectric constant: 2.7, manufactured using technology developed by Applied Materials, Inc.) being a compound having Si-CH₃ bonds is employed.

In a case where the metal wiring layer as an object to be polished by the polishing compound of the present invention is at least one member selected from copper, a copper alloy and a copper compound, a high effect can be obtained. However, the polishing compound of the present invention can be applied also to a metal other than copper, such as a metal film of e.g. Al, W, Ag, Pt or Au.

The polishing compound of the present invention can be applied to a polishing method wherein the polishing compound is supplied to a polishing pad, which is brought in contact with the surface to be polished, and the surface to be polished and the polishing pad are relatively moved to carry out polishing. If necessary, a pad conditioner may be contacted to the surface of the polishing pad, so that polishing is carried out while conditioning of the surface of the polishing pad is carried out.

Thus, the polishing compound of the present invention is useful for a method wherein at the surface to be polished prepared by forming concave portions such as trench patterns for wiring or via holes in an insulating layer on a substrate, then forming a barrier layer and then depositing a metal such as copper by a sputtering method or a plating method to embed such a metal in the trench portions, the metal and the barrier layer are removed by CMP until the insulating layer surface other than the concave portions will be exposed, thereby to form an embedded metal wiring layer.

Further, in the present invention, the removal rate selective ratio of low dielectric constant insulating layer/cap layer, specifically SiOC/silicon dioxide is preferably within a range of 0.04 to 0.50, more preferably from 0.05 to 0.30.

### EXAMPLES

Now, the present invention will be described in further detail with reference to Examples (Examples 1 to 9) and Comparative Examples (Examples 10 to 13).
(1) Preparation of Polishing Compounds
   (a) Polishing compounds of Examples 1 to 5 and 8 to 13 were prepared as followed. To water, the acid (D) and the pH buffer were added, and the basic compound (E) was further added, followed by stirring for 10 minutes to obtain liquid a. Then, the protective film-forming agent (C) was dissolved in ethylene glycol as a good solvent for (C) to obtain liquid b in which the solid content concentration of the protective film-forming agent (C) was 40 mass%.
      Then, an aqueous dispersion of abrasive particles (A) was gradually added to liquid b, and then the basic compound (E) was gradually added to adjust the pH to 3. Then, an aqueous solution of the oxidizing agent (B) was further added, followed by stirring for 30 minutes to obtain a polishing compound. The concentrations (mass%) of components (A) to (E) used in each Example, based on the total mass of the polishing compound, are shown in Table 1 together with other property values. As the water, pure water was used. Further, the content of ethylene glycol in each of the polishing compounds of Examples 1 to 5 and 8 to 13 was 1.5 mass%.
   (b) Polishing compounds of Examples 6 and 7 were prepared as follows. To water, the protective film-forming agent (C), the acid (D) and the pH buffer were added, and the basic compound (E) was further added, followed by stirring for 10 minutes to obtain a liquid, to which ethylene glycol as a solvent was further added to obtain liquid c.

   Then, an aqueous dispersion of abrasive particles (A) was gradually added to the liquid c, and then, the basic compound (E) was gradually added to adjust the pH to 3. Then, an aqueous solution of the oxidizing agent (B) was added, followed by stirring for 30 minutes to obtain a polishing compound of Example 6 or 7. The concentrations (mass%) of components (A) to (E) used in each Example, based on the total mass of the polishing compound, are shown in Table 1 together with other property values. As the water, pure water was used. Further, the content of ethylene glycol in each of the polishing compounds of Examples 6 and 7 was 1.5 mass%.
(2) Measurements of Average Primary Particle Size, Average Secondary Particle Size and Association Ratio of Abrasive particles
   The average primary particle size of abrasive particles was obtained as a particle size of equivalent spheres from the specific surface area of particles obtained by drying an aqueous dispersion. The specific surface area of particles was measured by a BET one point method being a nitrogen adsorption method by using FlowSorb II 2300 Model (manufactured by Shimadzu Corporation). The average secondary particle sizes of an aqueous dispersion and a polishing compound were measured by a MICROTRAC UPA (manufactured by Nikkiso Co., Ltd.) Here, in Example 13 in Table 1 (1), a result showing that the average secondary particle size in the aqueous dispersion is smaller than the average primary particle size, was obtained. This is a result caused by the difference of the measuring methods of both. From a result of observation of the aqueous dispersion of Example 13 by an electron microscope, Example 13 was confirmed to be monodisperse particles.
(3) Polishing Conditions
   Polishing was carried out by the following apparatus and conditions.
   Polishing machine: Full automatic CMP apparatus MIRRA (manufactured by Applied Materials, Inc.)
   Polishing pressure: 14 kPa
   Rotational speed: Platen (polishing platen) 103 rpm, head (substrate-holding portion) 97 rpm
   Polishing compound supply rate: 200 ml/min
   Polishing pad: IC1400 (manufactured by Rodel, Inc.)
(4) Objects to be Polished
   The following Blanket wafers (a) to (d) were used.
   (a) Wafer for evaluation of removal rate of metal wiring layer
      An 8-inch wafer having a copper layer having a thickness of 1,500 nm formed on a substrate by plating, was used.
   (b) Wafer for evaluation of removal rate of barrier layer
      An 8-inch wafer having a tantalum layer having a thickness of 200 nm formed on a substrate by sputtering, was used.
   (c) Wafer for evaluation of removal rate of cap layer
      An 8-inch wafer having a silicon dioxide layer having a thickness of 800 nm formed on a substrate by plasma CVD, was used.
   (d) Wafer for evaluation of removal rate of low dielectric constant insulating layer

   An 8-inch wafer having a SiOC layer having a thickness of 800 nm formed on a substrate by plasma CVD, was used.
(5) Method for evaluation of removal rate
   The removal rate was calculated from the layer thickness before and after the polishing. For the measurement of the layer thickness, with respect to copper and tantalum, a sheet resistance measuring apparatus RS75 (manufactured by KLA-Tencor Corporation) was used whereby the layer thickness was calculated from the surface resistance by a four probe method, and with respect to the low dielectric constant insulating layer and the cap layer, an optical interferotype fully automatic layer thickness measuring apparatus UV1280SE (manufactured by KLA-Tencor Corporation) was used.
(6) Evaluation of polishing properties of Blanket wafers

The above-mentioned respective Blanket wafers were used for evaluation of the respective removal rates of the metal wiring layer, the barrier layer, the cap layer and the low dielectric constant insulating layer. For this evaluation, polishing compounds having the compositions of the above-mentioned respective Examples were used.

Table 2 shows the removal rates (unit: nm/min) of the respective layers of copper, tantalum, silicon dioxide and SiOC, obtained by using the Blanket wafers. From the results, it is understood that the polishing compounds of the present invention have a high removal rate of the cap layer, a relatively low removal rate of the low dielectric constant insulating layer made of SiOC being a low dielectric constant material, and by utilizing such a nature, after removal of the cap layer by polishing, polishing can be carried out without removing the low dielectric constant insulating layer so much, and thus it is possible to obtain a polishing compound particularly suitable for polishing in a case where a high polishing selective ratio of the insulating layer is required.

Further, the removal rate of Ta or the removal rate of Cu can be made to be the same level as in Example 10 (Comparative Example). It is thereby understood that the polishing compound of the present invention can be used suitably, when polishing a surface to be polished in a case where a barrier layer and a metal wiring layer are formed in this order on a low dielectric constant insulating layer of a semiconductor integrated circuit device, and planarizing the surface to be polished after completely removing the barrier layer and the cap layer while suppressing the removal of the low dielectric constant insulating layer therebeneath to be minimum.

Further, on the basis of the polishing compound of Example 1 as a standard, with respect to one wherein the type of the protective film-forming agent (C) is changed, one wherein the type of the basic compound (E) is changed, and one wherein the association ratio is changed, polishing solutions can be prepared in the same manner as in Example 1 with the compositions shown in Table 1. With respect to the obtainable polishing solutions (Examples 2 to 9), evaluation is carried out in the same manner as in Example 1, whereby the results as shown in Table 2 are obtainable.

Here, in Example 9, as shown in Table 2, the removal rate of SiOC is slightly high as compared with Examples 1 to 8, but it is evident that this is an Example suitable for the second polishing step wherein Ta is polished at a high removal rate and silicon dioxide can be polished at a removal rate higher than Cu.

In Example 10, as shown in Table 2, the removal rate of silicon dioxide and SiOC are substantially equal, and it is evident that even after removal of the cap layer, polishing of the low dielectric constant material layer will proceed easily.

Further, in Examples 11 and 12, as shown in Table 2, it is evident that although the removal rate selective ratio of SiOC/silicon dioxide can be suppressed to the same level as in Examples 1 to 9, the removal rate of Ta is extremely slow as compared with Examples 1 to 9, such being not suitable for the second polishing step.

Further, in Example 13, as shown in Table 2, the removal rate of SiOC is substantially higher than the removal rate of silicon dioxide, and it is evident that after removal of the cap layer, removal of the low dielectric constant insulating layer will rapidly proceed.

Further, the dispersion stability of a polishing compound was evaluated by the change in the average primary particle size between immediately after the preparation and upon expiration of one week. A case wherein the increase in the average secondary particle size was within 50%, was evaluated to be "good", and a case wherein the increase was larger, or gelation resulted, was evaluated to be "no good". In each of Examples 1 to 13, the dispersion stability was good.

Further, as a result of the microscopic observation, no scratches were observed on the surface of the wafers for evaluation of removal rate of metal wiring layer, which were used in Examples.

**TABLE 1 (1)**

| Ex. | Abrasive particles (A) | | | | | |
|---|---|---|---|---|---|---|
| | Name | Concentration | BET specific surface area | Average primary particle size | Average secondary particle size * | Association ratio * |
| | | mass% | m²/g | nm | nm | |
| 1 | Silica | 6 | 116 | 24 | 24 | 1.02 |
| 2 | Silica | 6 | 77 | 35 | 58 | 1.64 |
| 3 | Silica | 6 | 117 | 23 | 36 | 1.52 |
| 4 | Silica | 6 | 117 | 23 | 36 | 1.52 |
| 5 | Silica | 6 | 117 | 23 | 36 | 1.52 |
| 6 | Silica | 6 | 117 | 23 | 36 | 1.52 |
| 7 | Silica | 6 | 117 | 23 | 36 | 1.52 |
| 8 | Silica | 6 | 92 | 30 | 60 | 2.02 |
| 9 | Silica | 6 | 117 | 23 | 36 | 1.52 |
| 10 | Silica | 6 | 78 | 35 | 45 | 1.29 |
| 11 | Silica | 6 | 117 | 23 | 36 | 1.52 |
| 12 | Silica | 6 | 117 | 23 | 36 | 1.52 |
| 13 | Silica | 6 | 162 | 17 | 13 | 0.78 |

| | | | | | | |
|---|---|---|---|---|---|---|
| *: Value in aqueous dispersion | | | | | | |

**TABLE 1 (2)**

| Ex. | Oxidizing agent (B) | | Protective film-forming agent (C) | | Acid (D) | | Basic compound (E) | |
|---|---|---|---|---|---|---|---|---|
| | Name | ** | Name | ** | Name | ** | Name | ** |
| | | mass% | | mass% | | mass% | | mass% |
| 1 | Hydrogen peroxide | 1 | BTA | 1 | Nitric acid | 0.6 | KOH | 0.6 |
| 2 | Hydrogen peroxide | 1 | BTA | 1 | Nitric acid | 0.6 | KOH | 0.6 |
| 3 | Hydrogen peroxide | 1 | BTA | 1 | Nitric acid | 0.6 | Ammonia | 0.5 |
| 4 | Hydrogen peroxide | 1 | BTA | 1 | Nitric acid | 0.6 | KOH | 0.6 |
| 5 | Hydrogen peroxide | 1 | BTA TTA | 0.2 0.2 | Nitric acid | 0.6 | KOH | 0.6 |
| 6 | Hydrogen peroxide | 1 | HAT | 1 | Nitric acid | 0.6 | Ammonia | 0.6 |
| 7 | Hydrogen peroxide | 1 | HT | 0.5 | Nitric acid | 0.6 | KOH | 0.6 |
| 8 | Hydrogen peroxide | 1 | BTA | 1 | Nitric acid | 0.6 | KOH | 0.6 |
| 9 | Hydrogen peroxide | 1 | BTA | 1 | Nitric acid | 0.06 | KOH | 0.7 |
| 10 | Hydrogen peroxide | 1 | BTA | 1 | Nitric acid | 0.6 | KOH | 0.6 |
| 11 | Hydrogen peroxide | 1 | BTA | 1 | Nil | 0 | KOH | 0.6 |
| 12 | Hydrogen peroxide | 1 | BTA | 1 | Nitric acid | 0.6 | Nil | 0 |
| 13 | Hydrogen peroxide | 1 | BTA | 1 | Nitric acid | 0.06 | KOH | 0.7 |

| | | | | | | | | |
|---|---|---|---|---|---|---|---|---|
| **Concentration | | | | | | | | |

**TABLE 1 (3)**

| Ex. | pH buffer | | Polishing compound slurry | |
|---|---|---|---|---|
| | Name | Concentration | Average secondary particle size | Association ratio |
| | | mass% | nm | - |
| 1 | Citric acid | 0.2 | 40 | 1.7 |
| 2 | Citric acid | 0.2 | 62 | 1.8 |
| 3 | Citric acid | 0.1 | 47 | 2.0 |
| 4 | Citric acid | 0.2 | 47 | 2.0 |
| 5 | Citric acid | 0.2 | 47 | 2.0 |
| 6 | Citric acid | 0.2 | 47 | 2.0 |
| 7 | Citric acid | 0.2 | 47 | 2.0 |
| 8 | Citric acid | 0.2 | 61 | 2.1 |
| 9 | Citric acid | 0.2 | 46 | 2.0 |
| 10 | Citric acid | 0.2 | 50 | 1.4 |
| 11 | Citric acid | 0.2 | 51 | 2.2 |
| 12 | Citric acid | 0.2 | 51 | 2.2 |
| 13 | Citric acid | 0.2 | 23 | 1.4 |

**TABLE 2**

| Ex. | Removal rate of Ta | Removal rate of Cu | Removal rate of silicon dioxide | Removal rate of SiOC | Removal rate ratio of SiOC/silicon dioxide |
|---|---|---|---|---|---|
| | nm/min | nm/min | nm/min | nm/min | - |
| 1 | 74 | 38 | 58 | 21 | 0.36 |
| 2 | 61 | 36 | 60 | 14 | 0.23 |
| 3 | 78 | 28 | 45 | 9 | 0.20 |
| 4 | 74 | 27 | 34 | 6 | 0.18 |
| 5 | 81 | 42 | 42 | 4 | 0.10 |
| 6 | 70 | 68 | 50 | 7 | 0.14 |
| 7 | 82 | 64 | 56 | 4 | 0.07 |
| 8 | 56 | 29 | 46 | 6 | 0.13 |
| 9 | 70 | 29 | 51 | 24 | 0.47 |
| 10 | 52 | 38 | 40 | 42 | 1.05 |
| 11 | 14 | 1 | 39 | 9 | 0.23 |
| 12 | 11 | 1 | 44 | 12 | 0.27 |
| 13 | 57 | 2 | 14 | 42 | 3.00 |

### INDUSTRIAL APPLICABILITY

The polishing compound for chemical mechanical polishing of the present invention is useful as a base material for high planarization technique in a process for forming multilayer wiring, such as preparation of a planarized surface of an insulating layer having an embedded metal wiring, in polishing of the surface to be polished in production of a semiconductor integrated circuit device, or preparation of a semiconductor integrated circuit device having a highly planarized multilayer structure.

The entire disclosure of Japanese Patent Application No. 2005-188284 filed on June 28, 2005 including specification, claims, drawings and summary is incorporated herein by reference in its entirety.

## Claims

1. A polishing compound for chemical mechanical polishing to polish a surface to be polished in production of a semiconductor integrated circuit device, which comprises abrasive particles (A) having an average primary particle size in a range of from 5 to 300 nm and an association ratio in the polishing compound in a range from 1.5 to 5, an oxidizing agent (B), a protective film-forming agent (C), an acid (D), a basic compound (E) and water (F).

2. The polishing compound according to Claim 1, wherein the protective film-forming agent (C) is made of at least one material selected from the group consisting of a compound represented by the formula (1), wherein R₁ is a hydrogen atom, a C₁₋₄ alkyl group, a C₁₋₄ alkoxy group or a carboxyl group, and a compound represented by the formula (2), wherein each of R₂ and R₃ which are independent of each other, is a hydrogen atom, a C₁₋₄ alkyl group, a C₁₋₄ alkoxy group, a carboxyl group or an amino group:

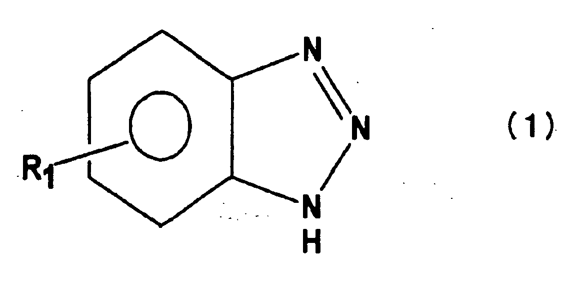

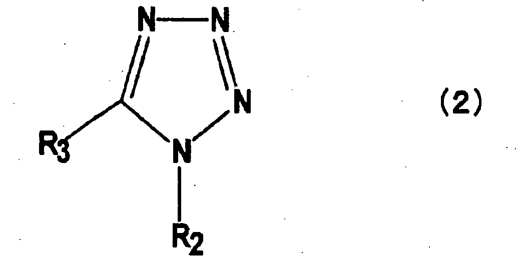

3. The polishing compound according to Claim 1 or 2, wherein the abrasive particles (A) are made of at least one material selected from the group consisting of silica, alumina, cerium oxide, zirconium oxide, titanium oxide, tin oxide, zinc oxide and manganese oxide.

4. The polishing compound according to Claim 3, wherein the abrasive particles (A) are made of colloidal silica.

5. The polishing compound according to Claim 1, 2, 3 or 4, which comprises from 0.1 to 20 mass% of the abrasive particles (A), from 0.01 to 50 mass% of the oxidizing agent (B), from 0.001 to 5 mass% of the protective film-forming agent (C), from 0.01 to 50 mass% of the acid (D), from 0.01 to 50 mass% of the basic compound (E) and from 40 to 98 mass% of water (F), based on the total mass of the above mentioned polishing compound being 100 mass%.

6. The polishing compound according to Claim 1, 2, 3, 4 or 5, which further contains a pH buffer and has a pH within a range of from 2 to 10.

7. The polishing compound according to any one of Claims 1 to 6, which is a polishing compound for polishing a surface to be polished in a case where a barrier layer and a metal wiring layer are formed in this order on an insulating layer.

8. The polishing compound according to any one of Claims 1 to 6, which is a polishing compound for polishing a surface to be polished in a case where a cap layer, a barrier layer and a metal wiring layer are formed in this order on an insulating layer made of a low dielectric constant material.

9. The polishing compound according to Claim 7 or 8, wherein the above metal wiring layer is made of copper, and the barrier layer is made of at least one member selected from the group consisting of tantalum, a tantalum alloy or a tantalum compound.

10. A method for producing of a semiconductor integrated circuit device having a metal wiring layer embedded in an insulating layer, which comprises using the polishing compound as defined in any one of Claims 1 to 9.
